# EUROPÄISCHE PATENTSCHRIFT

(11) **EP 2 383 771 B1**
(45) Veröffentlichungstag und Bekanntmachung des Hinweises auf die Patenterteilung: **22.04.2020**
(21) Anmeldenummer: 10004509.5
(22) Anmeldetag: 29.04.2010
(51) Int. Cl.: H01L 21/67

(54) **Vorrichtung und Verfahren zum Lösen einer Polymerschicht von einer Oberfläche eines Substrats**
Method and device for loosening a polymer coating from a surface of a substrate
Dispositif et procédé d'enlèvement d'une couche polymère de la surface d'un substrat

(43) Veröffentlichungstag der Anmeldung: 02.11.2011
(73) Patentinhaber: EV Group GmbH, 4782 St. Florian am Inn (AT)
(72) Erfinder: Crowder, Matt, Allen, Texas 75002 (US); Holzleitner, Ronald, 4644 Scharnstein (AT); Glinsner, Thomas, 4782 St. Florian/Inn (AT); Lindner, Paul, 4780 Schärding (AT); Thallner, Erich, AT - 4782 St. Florian (AT)
(74) Vertreter: Schweiger, Johannes

(56) Entgegenhaltungen:
- EP-A1- 1 583 135
- US-A1- 2003 183 246
- US-A1- 2004 211 442
- US-A1- 2005 205 521
- US-A1- 2007 163 711
- US-A1- 2008 072 925
- US-B1- 6 847 014
- Ingegard Johansson, P. Somasundaran: "Handbook for Cleaning/Decontamination of Surfaces", 20 June 2007 (2007-06-20), Elsevier, Amsterdam ISBN: 978-0-444-51664-0 vol. 1 * page 469 - page 475 *

## Beschreibung

Die Erfindung betrifft eine Vorrichtung und ein Verfahren zum Lösen einer Polymerschicht von einer Oberfläche eines Substrats gemäß Anspruch 1 oder Anspruch 9 Auf Substraten aufgebrachte Polymere, insbesondere Photolacke, werden im Stand der Technik durch Säuren und/oder Basen in einem einstufigen oder mehrstufigen Prozess entfernt, wobei in manchen Fällen unterhalb des in diesem Fall permanenten Photolacks zwischen dem Substrat und dem permanenten Photolack eine weitere, leichter lösbare Schicht aufgebracht werden kann.

Die EP 1 583 135 A1 zeigt eine Flüssigkeitsheizeinrichtung mit einem Kopf, durch welchen die geheizte Flüssigkeit durch einen Auslass zu einer Oberfläche eines Wafers gefördert wird. Die US 2008/0072925 A1 zeigt einen Waferreinigungsapparat zur beidseitigen Reinigung eines Wafers mit Heizmitteln zum Aufheizen der Reinigungsflüssigkeit. Die US 20031183246 A1 zeigt eine Reinigungsvorrichtung, welche mit Ultraschall arbeitet. Die US 2005/205521 A1 zeigt eine Nassätzvorrichtung mit zugehörigem Verfahren.

Je nach dem für die entsprechende Anwendung geeigneten Polymere mit den gewünschten physikalischen und chemischen Eigenschaften besteht häufig das Problem, dass das Ablösen eines optimalen Polymers besonders schwierig ist, da diese Polymere meist als permanente Polymerschicht auf dem Substrat aufgebracht sind, wie es insbesondere bei der Lithographieverfahren in der modernen Halbleiterindustrie überwiegend der Fall ist.

Ein Beispiel für ein Verfahren und eine Vorrichtung zum Lösen einer Polymerschicht ist in der US 2002/0033183 A1 gezeigt.

Da gerade die als permanent bezeichneten Polymerschichten besonders gute physikalische und/oder chemische Eigenschaften besitzen, stellt sich das technische Problem, dass die Polymerschichten darauf ausgelegt sind, nicht abgelöst zu werden.

Bei der Ablösung beziehungsweise Auflösung solcher Polymerschichten besteht daher insbesondere das Problem, dass starke chemische Reaktanten eingesetzt werden müssen, die schwer handhabbar sind und deren optimale Reaktionstemperatur möglichst genau eingehalten werden sollte, um eine optimale Wirkung zu entfalten.

Im Hinblick auf die vorgenanten technischen Probleme stellt sich daher die Aufgabe, eine Vorrichtung beziehungsweise ein Verfahren anzugeben, mit dem eine möglichst exakte Einhaltung der für das Lösen der Polymerschicht erforderlichen chemischen/physikalischen Parameter ermöglicht wird, bei gleichzeitig möglichst schneller und restloser Ablösung/Auflösung der Polymerschicht.

Diese Aufgabe wird mit den Merkmalen der Ansprüche 1 und 9 gelöst.

Vorteilhafte Weiterbildungen der Erfindung sind in den Unteransprüchen angegeben.

Der Erfindung liegt der Gedanke zu Grunde, die für das Lösen der Polymerschicht durch das die Polymerschicht lösende Fluid optimale Temperatur derart direkt in das auf der Polymerschicht aufgebrachte Fluid einzubringen, dass die Wärme zumindest überwiegend durch Wärmeleitung, also direkten Kontakt eines Heizmittels mit dem Fluid, erfolgt. Hierdurch kann die Temperatur des Fluids schnell und genau beeinflusst werden. Es ist daher erfindungsgemäß insbesondere möglich, die Temperatur des Fluids durch Anbringung entsprechender Temperatursensoren am Heizmittel zu messen. Auf eine Temperaturmessung des Fluids kann erfindungsgemäß sogar verzichtet werden, indem die Temperatur der Heizfläche des Heizmittels zur Steuerung verwendet wird.

Weiterhin wird erfindungsgemäß ermöglicht, auf eine zwischen der Polymerschicht und dem Substrat eingebrachte Zwischenschicht zu verzichten, so dass nur die auf das Substrat aufzubringende Polymerschicht, insbesondere permanente Polymerschicht, vorzugsweise als permanenter Photolack, aufgebracht wird. Dies führt zu einer Vereinfachung und Beschleunigung des Verfahrens und ist gleichzeitig kostengünstiger.

Erfindungsgemäß ist vorgesehen, dass zusätzlich zu den Heizmitteln an der Substrataufnahme, insbesondere an einer Kontaktfläche der Substrataufnahme mit dem Substrat, Substratheizmittel zum Heizen des Substrats und/oder Isoliermittel zum Isolieren des Substrats zur Reduzierung des Wärmeflusses vorgesehen sind. Durch diese Maßnahme wird der Temperaturgradient von der Heizfläche bis zur Kontaktfläche minimiert, so dass in der Polymerschicht mit zunehmenden Abstand von der Heizfläche der Heizmittel eine möglichst homogene Temperaturverteilung beziehungsweise annähernd konstante Temperaturverteilung erreicht werden kann.

Indem die Heizmittel mit Abstand zu der Polymerschicht, insbesondere parallel zur Oberseite der Polymerschicht, anordenbar sind, wobei der Abstand einstellbar ist, insbesondere durch, vorzugsweise senkrecht zur Oberseite ausführbare, Bewegung der Heizfläche, wird eine weitere Optimierung der Temperaturverteilung entlang des auf der Polymerschicht befindlichen Fluids erreicht.

Mit Vorteil weist die Heizfläche einen Durchmesser H von mindestens einem Drittel, insbesondere mindestens etwa der Hälfte, des Durchmessers D der Polymerschicht oder etwa die Hälfte des Durchmessers D auf oder sie entspricht dem Durchmesser D in etwa. Die vorgenannten alternativen Ausführungsformen stellen die erfindungsgemäß besonders vorteilhaften Ausführungsformen dar und durch eine größere Heizfläche wird das Aufheizen des Fluids auf der Polymerschicht entsprechend beschleunigt.

Soweit die Substrataufnahme Rotationsmittel zur Rotierung des Substrats um dessen Zentrum Z aufweist, lässt sich einerseits das Fluid optimal auf der Polymerschicht verteilen und andererseits ist eine Anordnung der Heizmittel neben den Einbringmitteln möglich, die bei einer vollflächigen Heizfläche nicht möglich ist.

Gemäß einer weiteren, vorteilhaften Ausführungsform der Erfindung ist vorgesehen, dass die Aufbringmittel eine oberhalb der Polymerschicht anordenbare Zuleitung zur Förderung des Fluids von einem Fluidvorratsraum zur Oberseite der Polymerschicht umfassen.

In einer weiteren vorteilhaften Ausführungsform der Erfindung ist vorgesehen, dass der Fluidvorratsraum als Mischraum zur Mischung des Fluids aus verschiedenen durch Leitungen zuführbaren Substanzen ausgebildet ist. Hierdurch erfüllt der Fluidvorratsraum mehrere Funktionen.

Durch die Maßnahme, dass die Aufbringmittel Vorheizmittel zur Aufwärmung des Fluids vor Aufbringung auf die Polymerschicht umfassen, kann das Verfahren weiter beschleunigt werden und der Temperaturgradient an der Heizfläche ist niedriger.

Indem die Vorrichtung einen durch ein Gehäuse begrenzten, insbesondere mit Vakuum beaufschlagbaren, Arbeitsraum umfasst, in welchem die Substrataufnahme, die Aufbringmittel und die Heizmittel zumindest teilweise angeordnet sind, wobei das Gehäuse über einen Auslass zur Ausbringung des Gemisches aus Fluid und durch das Fluid gelöster Polymerschicht aufweist, wird die Umgebung optimal vor den sehr reaktiven Substanzen des Fluids geschützt.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1:: einen schematischen Aufbau einer erfindungsgemäßen Vorrichtung gemäß einer ersten Ausführungsform im Querschnitt und
- Fig. 2:: einen schematischen Aufbau einer erfindungsgemäßen Vorrichtung gemäß einer zweiten Ausführungsform der Erfindung.

In den Figuren sind gleiche Bauteile und Bauteile mit der gleichen Funktion mit den gleichen Bezugszeichen gekennzeichnet.

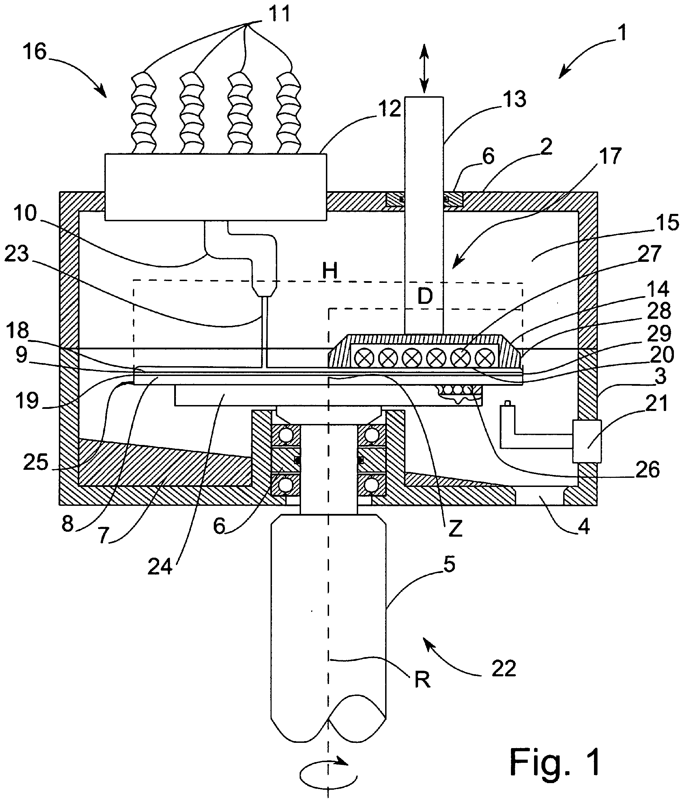

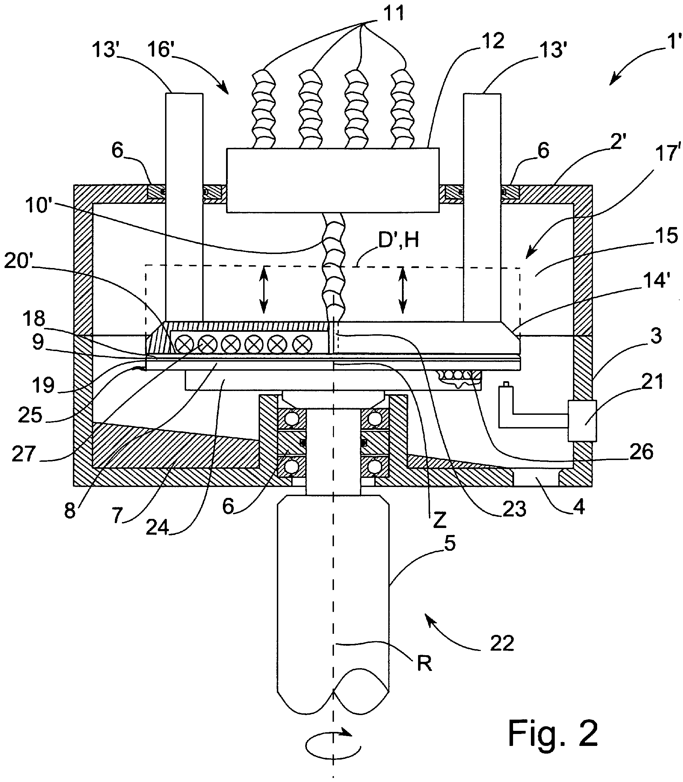

Die Figuren 1 und 2 zeigen jeweils eine Vorrichtung, um eine Polymerschicht 18, insbesondere einen permanenten Photolack, von einem Substrat 8, insbesondere einem Wafer, chemisch zu entfernen. Soweit nachfolgend nichts anderes beschrieben ist, haben die nachfolgend aufgeführten Bauteile der Vorrichtung den gleichen Aufbau beziehungsweise die gleiche Funktion, so dass der Aufbau und die Funktion zunächst am Beispiel der Figur 1 beschrieben werden.

Die Vorrichtung besteht aus einem Gehäuse 1. 1', das aus einem Oberteil 2, 2' und einem das Oberteil 2, 2' tragenden Unterteil 3 aufgebaut ist. Das Gehäuse 1, 1' kann alternativ auch mit einem Deckel oder einer seitlichen, verschließbaren Öffnung einteilig ausgebildet sein.

Das Gehäuse 1, 1' umschließt einen Arbeitsraum 15, in welchem die Polymerschicht 18 von dem Fluid 23 aufgelöst wird. Am tiefsten Punkt des Gehäuses 1, 1' ist ein Auslass 4 vorgesehen, durch den überflüssiges Fluid 23 oder ein Gemisch aus dem Fluid 23 und der von dem Fluid 23 aufgelösten Polymerschicht 18 abgesaugt wird, insbesondere durch eine nicht dargestellte Vakuumeinrichtung, die gleichzeitig für die Beaufschlagung des Arbeitsraums 15 mit einem Vakuum verwendbar ist. An dem Auslass 4 kann außerdem ein Abscheider und/oder ein Filter vorgesehen sein.

Das Substrat 8 wird von einem Probenhalter 24 einer Substrataufnahme 22 aufgenommen und durch übliche Mittel, beispielsweise an der Oberfläche des Probenhalters 24 vorgesehene Saugbahnen, fixiert, und zwar in einer ausgerichteten Position. Die ausgerichtete Position heißt, dass ein Zentrum Z des Substrats 8, insbesondere dessen Flächenschwerpunkt oder geometrische Mitte auf einer Rotationsachse R der durch eine Welle 5 rotierbaren Substrataufnahme 22 liegt.

Das Substrat 8 liegt mit seiner Rückseite 25 auf der Oberfläche des Probenhalters 24 auf. Die Polymerschicht 18 auf einer zur Rückseite 25 gegenüberliegenden Oberseite 19 des Substrats 8 wird durch Aufbringmittel 16, 16' mit dem Fluid 23 benetzt, insbesondere vollflächig bedeckt. Die Aufbringmittel 16, 16' bestehen aus Leitungen 11, die eine oder mehrere Substanzen und/oder Gase in einen als Mischraum wirkenden Fluidvorratsraum 12 einleiten, wobei ein bestimmtes Mengenverhältnis durch eine nicht gezeigte Steuerung vorgegeben wird und/oder einstellbar ist. In dem Mischraum erfolgt eine Vermischung der Flüssigkeiten und/oder Gase zu dem Fluid 23. Jede der Leitungen 11 kann mit Vorteil durch eine Vorwärmeinrichtung (nicht dargestellt) beheizbar ausgebildet sein, um die Flüssigkeit oder das Gas auf eine vorgegebene Temperatur vorzuwärmen. Zusätzlich oder alternativ besteht die Möglichkeit, den Fluidvorratsraum 12 mit einer Vorheizeinrichtung vorzuheizen, insbesondere auf eine nahe der optimalen Prozesstemperatur des Fluids 23 liegende Temperatur. Über die Steuereinrichtung wird das Fluid 23 über eine Zuleitung 10, 10' auf die Polymerschicht 18 aufgebracht und dort selbsttätig oder durch Rotation der Substrataufnahme 22 homogen verteilt.

Gemäß einer vorteilhaften Ausführungsform ist der Probenhalter 24 so ausgebildet, dass eine möglichst große Wärmeisolierung gegenüber dem Substrat 8 vorgesehen ist oder der Probenhalter 24 mit einer zusätzlichen Heizeinrichtung versehen ist.

Gemäß einer bevorzugten Ausführungsform weist der Probenhalter 24 eine Vielzahl von an der Rückseite 25 anliegenden Kontaktpunkten auf, insbesondere gebildet durch eine kugelförmige Oberfläche oder eine Vielzahl von in einer Wanne des Probenhalters eingelegten Kugeln 26, wodurch die Isolierwirkung mit Luft oder Vakuum als Isolator optimiert wird.

Gemäß einer alternativen Ausführungsform kann der Probenhalter 24 zumindest teilweise aus einem Material gefertigt werden, welches eine geringe thermische Leitfähigkeit besitzt.

Nach Aufbringung des Fluids 23 auf die Polymerschicht 18 wird die Polymerschicht 18 durch Heizmittel 17, 17' auf die optimale Prozesstemperatur des Fluids 23 aufgeheizt. Die Heizmittel 17, 17' bestehen aus mindestens einem Führungsarm 13, 13', der senkrecht zu einer Oberseite 9 der Polymerschicht 18 verfahrbar ist, und zwar gesteuert durch die Steuereinrichtung. Am unteren Ende des Führungsarms 13 beziehungsweise der Führungsarme 13' ist eine Heizeinrichtung 14, 14' angebracht mit einer zur Oberseite 9 parallel ausgerichteten Heizfläche 20, 20', die durch Heizwendeln 27 mit einer einstellbaren Temperatur beheizbar ist.

Statt der Heizwendeln 27 ist es in alternativer Ausführungsform der Erfindung möglich, eine Infrarot- oder Induktionsheizung vorzusehen. Entscheidend ist, dass die Heizfläche 20, 20' das auf der Polymerschicht 18 aufgebrachte Fluid 23 kontaktiert, vorzugsweise in das Fluid eintaucht.

An der Heizeinrichtung 14, 14' ist in vorteilhafter Ausgestaltung der Erfindung eine Abstandsmessung zur Messung des Abstands zwischen der Heizfläche 20, 20' und der Polymerschicht 18 vorgesehen.

In der in Figur 1 gezeigten Ausführungsform weist die Heizeinrichtung 14 einen Durchmesser D von etwa der Hälfte des Durchmessers H der Polymerschicht 18 auf. Die Heizfläche 20 erstreckt sich daher im Querschnitt über den halben Durchmesser H der Polymerschicht 18, wobei ein Rand 28 der Heizfläche 20 im Bereich eines Randes 29 der Polymerschicht 18 angeordnet ist, so dass bei Rotation des Substrats 8 durch die Substrataufnahme 22 um die Rotationsachse R spätestens nach einer ganzen Umdrehung des Substrats 8 um die Rotationsachse R die Polymerschicht 18 beziehungsweise das Fluid 23 vollständig von der Heizfläche 20 beaufschlagt worden ist.

Im Fall der in Figur 2 gezeigten Ausführungsform der Erfindung ist der Durchmesser D' der Heizeinrichtung 14' in etwa gleich groß wie der Durchmesser H der Polymerschicht 18, so dass die Heizfläche 20' im Wesentlichen der Fläche der Obersseite 9 der Polymerschicht 18 spricht. Dies hat den Vorteil, dass das Fluid 23 schneller aufheizt. Dafür ist der Aufbau der Zuleitung 10' aufwendiger, da diese in der gezeigten Ausführungsform die Heizeinrichtung 14' im Bereich des Zentrums Z durchsetzt, so dass das Fluid 23 in etwa im Bereich des Zentrums Z auf die Polymerschicht 18 aufgebracht werden kann.

Die Führungsarme 13, 13' können beispielsweise über Linearmotoren, gesteuert von der Steuereinrichtung, angetrieben sein, wobei die Führungsarme 13, 13' zur vorteilhaften Anordnung der Antriebe außerhalb des Arbeitsraums 15 das Gehäuse 1, 1' durchsetzend angeordnet sind. Dabei ist es besonders vorteilhaft, die Führungsarme 13, 13' durch Dichtungen 6 abzudichten, damit nichts auf diesem Wege aus dem Arbeitraum 15 entweichen kann. Gleichzeitig wird hierdurch die Größe des Arbeitsraums 15 minimiert und ermöglicht, ein höheres und konstantes Vakuum anzulegen.

Ebenso ist es vorteilhaft, die Welle 5 und deren nicht gezeigten Rotationsantrieb außerhalb des Arbeitsraums 15 anzuordnen, so dass die Welle 5 das Gehäuse 1, 1' durchsetzend ausgebildet ist und auch hier eine Dichtung 6 vorgesehen ist.

Damit das Fluid 23 und/oder das Gemisch aus Fluid 23 und durch das Fluid gelöstes Polymer der Polymerschicht 18 besser zum Auslass 4 abläuft, ist eine Gefälleeinrichtung 7 zur Erzeugung eines Gefälles, hier in Form einer Schräge, vorgesehen. Die Gefälleeinrichtung 7 kann auch durch entsprechende Ausformung des Unterteils 3 vorgesehen sein.

Nachdem die Polymerschicht 18 durch das Fluid 23 aufgelöst und gegebenenfalls durch Rotation der Substrataufnahme 22 abgeschleudert worden ist, findet eine Reinigung des Substrats 8, insbesondere mit Wasser und/oder Lösungsmitteln und/oder dafür vorgesehenen Chemikalien, statt die durch die Aufbringmittel 16, 16' auf das Substrat 8 aufgebracht werden. Gemäß einer alternativen Ausführungsform der Erfindung ist eine gesonderte Aufbringeinrichtung für die Reinigungsflüssigkeit vorgesehen, um die Reinigungsflüssigkeit nicht durch Chemikalienreste des Fluids 23 in den Aufbringmitteln 16, 16' zu verunreinigen.

Weiterhin ist eine gesonderte Reinigungseinrichtung 21 zur Reinigung der Substratunterseite, insbesondere am Rand des Substrats 8 vorgesehen, wobei die Reinigung vorzugsweise an einer Stelle des Umfangs des Substrats 8 während der Rotation des Substrats 8 durch die Substrataufnahme 22 erfolgt.

Darüber hinaus ist in einer Ausführungsform der Erfindung vorgesehen, die Oberseite des Substrats 8 und/oder die Heizeinrichtung 14, 14' mit einem Inertgas, insbesondere Stickstoff zu spülen, um eine Oxidation oder Zündreaktionen durch die hohen Temperaturen zu vermeiden.

Vorrichtung und Verfahren zum Lösen einer Polymerschicht von einer Oberfläche eines Substrats

### Bezugszeichenliste

- 1, 1': Gehäuse
- 2, 2': Oberteil
- 3: Unterteil
- 4: Auslass
- 5: Welle
- 6: Dichtung
- 7: Gefälleeinrichtung
- 8: Substrat
- 9: Oberseite
- 10, 10': Zuleitung
- 11: Leitungen
- 12: Fluidvorratsraum
- 13, 13': Führungsarm
- 14, 14': Heizeinrichtung
- 15: Arbeitsraum
- 16, 16': Aufbringmittel
- 17, 17': Heizmittel
- 18: Polymerschicht
- 19: Oberseite
- 20, 20': Heizfläche
- 21: gesonderte Reinigungseinrichtung
- 22: Substrataufnahme
- 23: Fluid
- 24: Probenhalter
- 25: Rückseite
- 26: Kugeln
- 27: Heizwendeln
- 28: Rad

- D, D': Durchmesser
- H: Durchmesser
- R: Rotationsachse
- Z: Zentrum

## Patentansprüche

1. Vorrichtung zum Lösen einer Polymerschicht (18) von einer Oberfläche (19) eines Substrats (8), nämlich eines Wafers, mit folgenden Merkmalen:
- einer Substrataufnahme (22) zur Aufnahme des Substrats (8) an einer der Oberseite (19) gegenüberliegenden Rückseite (25) des Substrats (8),
- Aufbringmittel (16, 16') zum Aufbringen eines Fluids (23) zum Lösen der Polymerschicht (18) auf die Polymerschicht (18), insbesondere die gesamte Oberseite (9) der Polymerschicht (18) und
- Heizmittel (17, 17') zum Einleiten von Wärme in das Fluid (23) durch Kontakt einer Heizfläche (20) der Heizmittel (17, 17') mit dem auf die Polymerschicht (18) aufgebrachten Fluid (23), **dadurch gekennzeichnet, dass** zusätzlich zu den Heizmitteln (17, 17') an
der Substrataufnahme (22) Substratheizmittel zum Heizen des Substrats vorgesehen sind, wobei an den Heizmitteln (17, 17') Temperatursensoren zur Messung und Regelung der Temperatur des Fluids (23) angebracht sind.

2. Vorrichtung nach einem der vorhergehenden Ansprüche, **dadurch gekennzeichnet, dass** die Heizmittel (17, 17') mit Abstand zu der Polymerschicht (18), insbesondere parallel zur Oberseite (9) der Polymerschicht (18), anordenbar sind, wobei der Abstand einstellbar ist, insbesondere durch, vorzugsweise senkrecht zur Oberseite (9) ausführbare, Bewegung der Heizfläche (20, 20').

3. Vorrichtung nach einem der vorhergehenden Ansprüche, **dadurch gekennzeichnet, dass** die Heizfläche (20, 20') einen Durchmesser H von mindestens einem Drittel, mindestens etwa der Hälfte, des Durchmessers D der Polymerschicht (18) oder etwa der Hälfte des Durchmessers D aufweist oder dem Durchmesser D etwa entspricht.

4. Vorrichtung nach einem der vorherigen Ansprüche, **dadurch gekennzeichnet, dass** die Substrataufnahme (22) Rotationsmittel (5) zur Rotierung des Substrats (8) um dessen Zentrum Z aufweist.

5. Vorrichtung nach einem der vorhergehenden Ansprüche, **dadurch gekennzeichnet, dass** die Aufbringmittel (16, 16') eine oberhalb der Polymerschicht (18) anordenbare Zuleitung (10, 10') zur Förderung des Fluids (23) von einem Fluidvorratsraum (12) zur Oberseite (9) der Polymerschicht (18) umfassen.

6. Vorrichtung nach Anspruch 5, **dadurch gekennzeichnet, dass** der Fludvorratsraum (12) als Mischraum zur Mischung des Fluids (23) aus verschiedenen, durch Leitungen (11) zuführbaren, Substanzen ausgebildet ist.

7. Vorrichtung nach einem der vorhergehenden Ansprüche, **dadurch gekennzeichnet, dass** die Aufbringmittel (16, 16') Vorheizmittel zur Aufwärmung des Fluids (23) vor Aufbringung auf die Polymerschicht (18) umfassen.

8. Vorrichtung nach einem der vorhergehenden Ansprüche, **dadurch gekennzeichnet, dass** die Vorrichtung einen durch ein Gehäuse (1, 1') begrenzten, insbesondere mit Vakuum beaufschlagbaren, Arbeitsraum (15) umfasst, in welchem die Substrataufnahme (22), die Aufbringmittel (16, 16') und die Heizmittel (17, 17') zumindest teilweise angeordnet sind, wobei das Gehäuse (1, 1') über einen Auslass (4) zur Ausbringung des Gemisches aus Fluid (23) und durch das Fluid (23) gelöster Polymerschicht (18) aufweist.

9. Verfahren zum Lösen einer Polymerschicht (18) von einer Oberfläche (19) eines Substrats (8), nämlich Wafers, mit folgenden Schritten:
- Aufnahme des Substrats (8) auf eine Substrataufnahme (22) an einer der Oberseite (19) gegenüberliegenden Rückseite (25),
- Aufbringen eines Fluids (23) zum Lösen der Polymerschicht (18) auf die Polymerschicht (18) durch Aufbringmittel (16, 16') und
- Einleiten von Wärme in das Fluid (23) durch Heizmittel (17, 17'), wobei eine Heizfläche (20, 20') der Heizmittel (17, 17') mit dem auf die Polymerschicht (18) aufgebrachten Fluid (23) in Kontakt gebracht wird, **dadurch gekennzeichnet, dass** zusätzlich zu den Heizmitteln (17, 17') an der Substrataufnahme (22) Substratheizmittel zum Heizen des Substrats vorgesehen sind, wobei mit an den Heizmitteln (17, 17') angebrachten Temperatursensoren die Temperatur des Fluids (23) gemessen und geregelt wird.

## Claims

1. A device for removing a polymer layer (18) from a surface (19) of a substrate (8), namely a wafer, with the following features:
- a substrate holder (22) for holding the substrate (8) at a rear side (25) of the substrate (8) lying opposite the upper side (19),
- application means (16, 16') for applying a fluid (23) for removing the polymer layer (18) onto the polymer layer (18), in particular the entire upper side (9) of the polymer layer (18) and
- heating means (17, 17') for introducing heat into the fluid (23) by contact of a heating surface (20) of the heating means (17, 17') with the fluid (23) applied onto the polymer layer (18), **characterised in that**, in addition to the heating means (17, 17'), substrate heating means for heating the substrate are provided on the substrate holder (22),
wherein
temperature sensors for measuring and controlling the temperature of the fluid (23) are fitted to the heating means (17, 17').

2. A device according to any one of the preceding claims, **characterised in that** the heating means (17, 17') can be arranged with a spacing from the polymer layer (18), in particular parallel to the upper side (9) of the polymer layer (18), wherein the spacing is adjustable, in particular by a movement of the heating surface (20, 20') which can be performed preferably perpendicular to the upper side (9).

3. The device according to any one of the preceding claims, **characterised in that** the heating surface (20, 20') has a diameter H of at least a third, at least approximately half of diameter D of the polymer layer (18) or approximately half of diameter D or corresponds approximately to diameter D.

4. The device according to any one of the preceding claims, **characterised in that** the substrate holder (22) comprises rotation means (5) for rotating the substrate (8) about its centre Z.

5. The device according to any one of the preceding claims, **characterised in that** the application means (16, 16') comprise a supply line (10, 10') which can be arranged above the polymer layer (18) for delivering the fluid (23) from a fluid storage space (12) to the upper side (9) of the polymer layer (18).

6. The device according to claim 5, **characterised in that** the fluid supply space (12) is designed as a mixing space for mixing the fluid (23) comprising different substances which can be supplied through lines (11).

7. The device according to any one of the preceding claims, **characterised in that** the application means (16, 16') comprise preheating means for heating up the fluid (23) before application onto the polymer layer (18).

8. The device according to any one of the preceding claims, **characterised in that** the device comprises a working space (15) which is limited by a housing (1, 1') and which can in particular be subjected to a vacuum, in which working space the substrate holder (22), the application means (16, 16') and the heating means (17, 17') are at least partially arranged, wherein the housing (1, 1') comprises an outlet (4) for recovering the mixture comprising fluid (23) and polymer layer (18) dissolved by the fluid (23).

9. A method for removing a polymer layer (18) from a surface (19) of a substrate (8), namely a wafer, with the following steps:
- receiving the substrate (8) on a substrate holder (22) at a rear side (25) lying opposite the upper side (19),
- applying a fluid (23) for removing the polymer layer (18) onto the polymer layer (18) by application means (16, 16') and
- introducing heat into the fluid (23) by heating means (17, 17'), wherein a heating surface (20, 20') of the heating means (17, 17') is brought into contact with the fluid applied to the polymer layer (18), **characterised in that**, in addition to the heating means (17, 17'), substrate heating means for heating the substrate are provided on the substrate holder (22),
wherein
the temperature of the fluid (23) is measured and controlled by temperature sensors which are fitted to the heating means (17, 17').

## Revendications

1. Dispositif pour séparer une couche de polymère (18) d'une surface (19) d'un substrat (8), à savoir une tranche, comprenant les attributs suivants :
- une réception de substrat (22) pour recevoir le substrat (8) sur un dos (25) du substrat (8) opposé à la face supérieure (19),
- des moyens d'application (16, 16') pour appliquer un fluide (23) pour séparer la couche de polymère (18) sur la couche de polymère (18), en particulier toute la face supérieure (9) de la couche de polymère (18) et
- des moyens de chauffage (17, 17') pour introduire de la chaleur dans le fluide (23) par contact d'une surface de chauffage (20) des moyens de chauffage (17, 17') avec le fluide (23) appliqué sur la couche de polymère (18), **caractérisé en ce que** des moyens de chauffage de substrat pour chauffer le substrat sont prévus en plus des moyens de chauffage (17, 17') sur la réception de substrat (22),
dans lequel
des capteurs de température pour mesurer et réguler la température du fluide (23) sont appliqués sur les moyens de chauffage (17, 17').

2. Dispositif selon l'une des revendications précédentes, **caractérisé en ce que** les moyens de chauffage (17, 17') peuvent être agencés à distance de la couche de polymère (18), en particulier parallèlement à la face supérieure (9) de la couche de polymère (18), dans lequel l'écart peut être réglé, en particulier par déplacement de la surface de chauffage (20, 20'), pouvant être exécuté de préférence verticalement à la face supérieure (9).

3. Dispositif selon l'une des revendications précédentes, **caractérisé en ce que** la surface de chauffage (20, 20') présente un diamètre H d'au moins un tiers, d'au moins environ la moitié, du diamètre D de la couche polymère (18) ou d'environ la moitié du diamètre D ou correspond environ au diamètre D.

4. Dispositif selon l'une des revendications précédentes, **caractérisé en ce que** la réception de substrat (22) présente des moyens de rotation (5) pour la rotation du substrat (8) sur son centre Z.

5. Dispositif selon l'une des revendications précédentes, **caractérisé en ce que** les moyens d'application (16, 16') comprennent une alimentation (10, 10') pouvant être agencée au-dessus de la couche de polymère (18) pour transporter le fluide (23) d'un espace de stockage de fluide (12) vers la face supérieure (9) de la couche de polymère (18).

6. Dispositif selon la revendication 5, **caractérisé en ce que** l'espace de stockage de fluide (12) est conçu en tant qu'espace de mélange pour mélanger le fluide (23) de différentes substances pouvant être alimentées par des lignes (11).

7. Dispositif selon l'une des revendications précédentes, **caractérisé en ce que** les moyens d'application (16, 16') comprennent des moyens de préchauffage pour réchauffer le fluide (23) avant l'application sur la couche de polymère (18).

8. Dispositif selon l'une des revendications précédentes, **caractérisé en ce que** le dispositif comprend un espace de travail (15) délimité par un boîtier (1, 1'), en particulier pouvant être alimenté par du vide, dans lequel la réception de substrat (22), les moyens d'application (16, 16') et les moyens de chauffage (17, 17') sont disposés au moins partiellement, dans lequel le boîtier (1, 1') dispose d'une sortie (4) pour évacuer le mélange de fluide (23) et de couche polymère (18) séparée par le fluide (23).

9. Procédé pour séparer une couche de polymère (18) d'une surface (19) d'un substrat (8), à savoir une tranche, comprenant les étapes suivantes :
- réception du substrat (8) sur une réception de substrat (22) sur un dos (25) du substrat (8) opposé à la face supérieure (19),
- application d'un fluide (23) pour séparer la couche de polymère (18) sur la couche de polymère (18) par des moyens d'application (16, 16') et
- introduction de chaleur dans le fluide (23) par des moyens de chauffage (17, 17'), dans lequel une surface de chauffage (20, 20') des moyens de chauffage (17, 17') est amenée en contact avec le fluide (23) appliqué sur la couche de polymère (18), **caractérisé en ce que** des moyens de chauffage de substrat sont prévus pour chauffer le substrat en plus des moyens de chauffage (17, 17') sur la réception de substrat (22),
dans lequel
la température du fluide (23) est mesurée et régulée avec des capteurs de température appliqués sur les moyens de chauffage (17, 17').
